# EUROPEAN PATENT APPLICATION

(11) **EP 3 804 983 A1**
(43) Date of publication of application: **14.04.2021**
(21) Application number: 19812369.7
(22) Date of filing: 29.05.2019
(51) Int. Cl.: B32B 15/14, D06M 11/83

(54) **LAYERED SHEET**

(30) Priority: 30.05.2018 JP 2018103141
(71) Applicant: SEKISUI CHEMICAL CO., LTD., Osaka-shi Osaka 530-8565 (JP)
(72) Inventor: MURAKAMI, Junnosuke, Gamagori-shi, Aichi 443-8623 (JP); KOJIMA, Tomotaka, Gamagori-shi, Aichi 443-8623 (JP)
(74) Representative: Ter Meer Steinmeister & Partner
(86) International application number: PCT/JP2019/021296
(87) International publication number: WO 2019/230798

(57) **Abstract**

An object of the invention is to provide a coloring technique by which more unevenness of a fiber substrate can be retained, luster can be imparted, and heat ray reflectivity can be improved. This problem can be solved by a laminated sheet comprising a fiber substrate and a metal layer disposed on the surface of the fiber substrate.

## Description

### Technical Field

The present invention relates to a laminated sheet etc.

### Background Art

Fiber substrates are used in various fields where designability is required. For example, a carbon fiber substrate forms a composite material together with a resin (e.g., carbon-fiber-reinforced plastic), and such composite materials are widely used in applications ranging from relatively large items such as aircraft bodies to relatively small and familiar items such as sporting goods, and car interior and exterior materials. The fiber substrates may thus be colored to enhance their designability.

Fiber substrates have been commonly colored by applying a paint containing a dye, a pigment, or the like (Patent Literature 1).

### Citation List

### Patent Literature

PTL 1: JP2010-229587A

### Summary of Invention

### Technical Problem

The present inventors focused on the fact that coloring a fiber substrate with a paint undesirably deteriorates visually recognizable optical characteristics, such as luster, or deteriorates the unevenness of the fiber substrate. Although these factors are all important in relation to designability, coloring would instead deteriorate the designability.

The present inventors also focused on the problem that external heat rays (e.g., sunlight rays) undesirably increase the temperature of the composite material, such as fiber-reinforced plastic obtained by using a fiber substrate. This problem, for example, leads to an increase in the temperature of a car when the composite material is used for car interior and exterior materials, resulting in deterioration of fuel efficiency.

In view of the above, an object of the present invention is to provide a coloring technique by which more unevenness of a fiber substrate can be retained, luster can be imparted, and heat ray reflectivity can be improved.

### Solution to Problem

The present inventors conducted extensive research and found that the above objects can be achieved by a laminated sheet comprising a fiber substrate and a metal layer disposed on a surface of the fiber substrate. The present inventors conducted further research based on this finding, and accomplished the present invention.

More specifically, the present invention includes the following embodiments.
Item 1. A laminated sheet comprising a fiber substrate and a metal layer disposed on a surface of the fiber substrate.
Item 2. The laminated sheet according to Item 1, wherein the metal layer contains at least one member selected from the group consisting of aluminum, copper, iron, silver, gold, chromium, nickel, molybdenum, titanium, platinum, germanium, indium, and silicon.
Item 3. The laminated sheet according to Item 1 or 2, further comprising an oxide layer on a surface of the metal layer opposite to the fiber substrate.
Item 4. The laminated sheet according to any one of Items 1 to 3, wherein the surface of the laminated sheet on the metal layer side has an infrared reflectance of 50% or more.
Item 5. The laminated sheet according to any one of Items 1 to 4, wherein the metal layer is composed of two or more layers having different compositions.
Item 6. The laminated sheet according to Item 5, wherein the outermost layer of the metal layer on a side opposite to the fiber substrate side is composed of a metal, alloy, or compound comprising at least one member selected from the group consisting of titanium, aluminum, silver, iron, copper, indium, and silicon, and
   wherein the outermost layer has a thickness of 3 to 20 nm.
Item 7. The laminated sheet according to any one of Items 1 to 6, wherein the fiber substrate is a sheet comprising carbon fiber.
Item 8. The laminated sheet according to any one of Items 1 to 7, for use as a heat-ray-reflecting material.
Item 9. A coated fiber comprising a fiber and a metal layer disposed on a surface of the fiber.
Item 10. A composite material comprising a resin and at least one member selected from the group consisting of the laminated sheet of any one of Items 1 to 8 and the coated fiber of Item 9.
Item 11. The composite material according to Item 10, for use as an automobile interior and exterior material.

### Advantageous Effects of Invention

The present invention can provide a laminated sheet, a coated fiber, and a coated fiber bundle, as well as a composite material comprising at least one of these and a resin, all of these having more remaining unevenness that originated from the fiber substrate, fiber, fiber bundle, or the like, and also having luster and improved heat ray reflectivity.

### Description of Embodiments

In the present specification, the terms "comprise" and "contain" include the concepts of comprising, containing, consisting essentially of, and consisting of.

### 1. Laminated Sheet

In one embodiment, the present invention relates to a laminated sheet comprising a fiber substrate and a metal layer disposed on the surface of the fiber substrate (which may be referred to as "the laminated sheet of the present invention" in the present specification). The laminated sheet is described below.

### 1-1. Fiber Substrate

The fiber substrate is not particularly limited as long as it is a substrate comprising fibers or fiber bundles as a material, and is in the form of a sheet. The fiber substrate may comprise components other than fibers and fiber bundles as long as the effects of the present invention are not significantly impaired. In this case, the total amount of fibers and fiber bundles in the fiber substrate is, for example, 80 mass% or more, preferably 90 mass% or more, more preferably 95 mass% or more, and even more preferably 99 mass% or more; and is usually less than 100 mass%. Examples of the fiber substrate include woven fabrics (e.g., plain weave, twill weave, and satin weave), knitted fabrics, nonwoven fabrics, paper, and the like. Among these, woven fabrics, knitted fabrics, and the like are preferable, and woven fabrics are more preferable, in terms of the relatively large uneven shape of the surface and more improved designability of the laminated sheet of the present invention.

The layer structure of the fiber substrate is not particularly limited. The fiber substrate may be composed of a single fiber substrate alone, or may be a combination of two or more fiber substrates.

The fibers constituting the fiber substrate are not particularly limited, and a wide variety of fibers can be used. Examples include carbon fibers (e.g., PAN-based carbon fibers, pitch-based carbon fibers, and carbon nanotubes); inorganic fibers, such as glass fibers (e.g., glass wool and glass fibers), mineral fibers (e.g., chrysotile, white asbestos, crocidolite, amosite, anthophyllite, tremolite, and actinolite), artificial mineral fibers (e.g., rock wool and ceramic fibers), and metallic fibers (e.g., stainless steel fibers, aluminum fibers, iron fibers, nickel fibers, and copper fibers); organic fibers, such as synthetic fibers (e.g., nylon fibers, polyester fibers, acrylic fibers, vinylon fibers, polyolefin fibers, polyethylene fibers, polypropylene fibers, and polyurethane fibers), regenerated fibers (e.g., rayon, polynosic, cupra, Lyocell, and acetate), plant fibers (e.g., cotton fibers, hemp fibers, flax fibers, rayon fibers, polynosic fibers, cupra fibers, Lyocell fibers, and acetate fibers), and animal fibers (e.g., wool, silk, silkworm gut, mohair, cashmere, camel, llama, alpaca, vicuna, angora, and spider silk); and the like. Among these, the fibers are, for example, preferably inorganic fibers, more preferably carbon fibers, and even more preferably PAN-based carbon fibers.

The fiber substrate preferably comprises a carbon material as the fibers constituting the fiber substrate, or as a component other than the fibers constituting the fiber substrate. The carbon material is not particularly limited. Examples include carbon fibers (e.g., PAN-based carbon fibers, pitch-based carbon fibers, and carbon nanotubes), carbon black, activated carbon, hard carbon, soft carbon, mesoporous carbon, graphene, carbon nanotubes, fullerenes, and the like. Among these, for example, carbon fibers or carbon fiber bundles are preferable, and PAN-based carbon fibers or bundles thereof are more preferable. When the fiber substrate comprises a carbon material as a component other than the fibers constituting the fiber substrate, the fiber substrate comprises a carbon material, for example, as a component for coating the fiber surface or a component for joining fibers; however, it is not limited thereto.

Coloring a carbon material is difficult except by applying a paint; however, coloring by applying a paint can deteriorate luster and unevenness specific to the carbon material. The present invention can further impart luster, in addition to the luster and unevenness specific to the carbon material.

The size of the fibers can vary depending on the type of fiber, and is not particularly limited. In the case of carbon fibers, for example, the average diameter is preferably about 1,000 to 30,000 nm (particularly, about 1,000 to 10,000 nm).

The form of the fibers may be any of the following: continuous long fibers, short fibers obtained by cutting continuous long fibers, milled yarn obtained by milling fibers into a powder, etc.

The fibers may be one type of fiber, or a combination of two or more types of fibers.

The fiber bundle is not particularly limited as long as it is composed of a plurality of fibers. The number of fibers constituting the fiber bundle is, for example, 500 or more, preferably 1000 or more, more preferably 1000 to 50000, even more preferably 1500 to 40000, and still more preferably 2000 to 30000.

The thickness of the fiber substrate can vary depending on the type of fiber, and is not particularly limited. The thickness of the fiber substrate is, for example, 0.01 to 10 mm, and preferably 0.05 to 5 mm.

### 1-2. Metal Layer

The metal layer is disposed on the fiber substrate. In other words, the metal layer is disposed on at least one of the two main surfaces of the fiber substrate.

The metal layer is not particularly limited as long as it is a layer comprising a metal as a material. A simple metal, an alloy, a metal compound, and the like can be used. The metal layer may comprise components other than metal as long as the effects of the present invention are not significantly impaired. In this case, the amount of metal in the metal layer is, for example, 80 mass% or more, preferably 90 mass% more, more preferably 95 mass% or more, and even more preferably 99 mass% or more; and is usually less than 100 mass%.

The layer structure of the metal layer is not particularly limited. The metal layer may be a single layer composed of one layer, or the metal layer may be composed of a plurality of layers having the same or different compositions. The metal layer is preferably composed of two or more layers (e.g., two layers, three layers, four layers, or five layers) having different compositions, for example, to make it possible to further suppress an increase in the surface temperature due to heat rays, and to make it easy to adjust coloring. Further, one or both of the two main surfaces of the metal layer may be composed of a film such as an oxide film.

Examples of the metal constituting the metal layer include, but are not particularly limited to, aluminum, copper, iron, silver, gold, chromium, nickel, molybdenum, titanium, platinum, gallium, zinc, tin, niobium, indium, silicon, germanium, and the like. Examples of the metal also include "metalloids."

The metals may be used singly, or in a combination of two or more. When used in a combination of two or more, examples of the combination include a combination that constitutes steel, such as a combination of iron and one or more other metals (e.g., nickel, chromium, aluminum, cobalt, copper, molybdenum, niobium, lead, titanium, and zinc).

From the viewpoint of luster, stability, human toxicity, environmental toxicity, processability, cost, and the like, the metal is preferably aluminum, silver, titanium, and the like, more preferably aluminum, silver, and the like, and still more preferably aluminum. Additionally, to further suppress an increase in the surface temperature due to heat rays, the metal is preferably silver, aluminum, titanium, and the like, more preferably silver, aluminum, and the like, and further preferably silver. These metals are particularly preferably used respectively as the constituent metal of the metal layer composed a single layer; when the metal layer is composed of a plurality of layers, these metals are particularly preferably used as the constituent metals of the layer of the metal layer on the fiber substrate side (i.e., the metal layer other than the outermost metal layer of the laminated sheet of the present invention).

To make it easier to adjust coloring, when the metal layer is composed of two or more layers having different compositions, the outermost layer of the metal layer on a side opposite to the fiber substrate side is preferably composed of a metal, alloy, or compound comprising at least one member selected from the group consisting of titanium, aluminum, silver, iron, copper, indium, and silicon, and more preferably composed of a metal, alloy, or compound comprising titanium.

The thickness of the metal layer is not particularly limited, and is, for example, 1 to 200 nm. From the viewpoint of designability and luster, and in order to further suppress an increase in the surface temperature due to heat rays, the thickness is preferably 5 to 100 nm, more preferably 10 to 100 nm, still more preferably 20 to 80 nm, even more preferably 30 to 80 nm, and particularly preferably 40 to 70 nm.

The thickness of the metal layer when composed of a single layer, or the thickness of the layer of the metal layer on the fiber substrate side when the metal layer is composed of a plurality of layers (i.e., the metal layer other than the outermost metal layer of the laminated sheet of the present invention), is, for example, 1 to 200 nm. From the viewpoint of designability and luster, and in order to further suppress an increase in the surface temperature due to heat rays, the thickness is preferably 5 to 100 nm, more preferably 10 to 80 nm, still more preferably 20 to 70 nm, even more preferably 30 to 60 nm, and particularly preferably 40 to 60 nm.

When the metal layer is composed of a plurality of layers, the thickness of the outermost metal layer of the laminated sheet of the present invention is, for example, 1 to 30 nm. From the viewpoint of designability and in order to further suppress an increase in the surface temperature due to heat rays, the thickness is preferably 3 to 20 nm, more preferably 5 to 15 nm, and still more preferably 7 to 12 nm.

In a preferred embodiment of the present invention, when the metal layer is composed of two or more layers having different compositions, the outermost layer of the metal layer on a side opposite to the fiber substrate side is preferably composed of a metal, alloy, or compound comprising at least one member selected from the group consisting of titanium, aluminum, silver, iron, copper, indium, and silicon, and more preferably composed of a metal, alloy, or compound comprising titanium, to make it easier to adjust coloring. Furthermore, the thickness of this outermost layer is preferably 3 to 20 nm, more preferably 5 to 15 nm, and still more preferably 7 to 12 nm. In this case, it is possible to not only impart metallic luster to the laminated sheet but also make it easy to adjust coloring.

The thickness of the metal layer can be determined by X-ray fluorescence analysis. More specifically, the analysis is performed using a scanning X-ray fluorescence analyzer (e.g., ZSX PrimusIII+ X-ray fluorescence spectrometer, produced by Rigaku Corporation, or an equivalent product) at an acceleration voltage of 50 kV, acceleration current of 50 mA, and integration time of 60 seconds. The X-ray intensity of the Kα ray of a metal component that is to be measured is measured, and the intensity at the background position is also measured in addition to the peak position so that the precise intensity can be calculated. From the calibration curve prepared in advance, the measured intensity value can be converted into a thickness. The same sample is analyzed five times, and the average value is defined as its thickness.

### 1-3. Oxide Layer

The laminated sheet of the present invention preferably further comprises an oxide layer on the surface of the metal layer opposite to the fiber substrate. The presence of an oxide layer can further improve durability, such as discoloration resistance.

The oxide layer is not particularly limited as long as it comprises a metal oxide or a metalloid oxide as a material. The oxide layer may comprise components other than the oxide as long as the effects of the present invention are not significantly impaired. In this case, the amount of the oxide in the oxide layer is, for example, 80 mass% or more, preferably 90 mass% or more, more preferably 95 mass% or more, and still more preferably 99 mass% or more; and is usually less than 100 mass%.

The metalloid oxide constituting the oxide layer is not particularly limited. Examples include oxides of metalloids, such as silicon, germanium, antimony, tellurium, bismuth, and selenium (preferably silicon). More specific examples of the metalloid oxide include compounds represented by AOx, wherein X is a number satisfying the following formula: n/2.5≤X≤n/2 (n is the valence of a metalloid); and A is a metalloid selected from the group consisting of silicon, germanium, antimony, tellurium, bismuth, and selenium. When A in the above formula is a metalloid element, A is preferably silicon; and the metalloid oxide is more preferably SiO₂, in terms of favorably adjusting the color tone of the laminated sheet. The metalloid oxides may be used singly, or in a combination of two or more.

The metal oxide constituting the oxide layer is not particularly limited. Examples include oxides of metals, such as titanium, aluminum, niobium, cobalt, and nickel (preferably titanium and aluminum). More specific examples of the metal oxide include compounds represented by AOₓ, wherein X is a number satisfying the following formula: n/2.5≤X≤n/2 (n is the valence of a metal); and A is a metal selected from the group consisting of titanium, aluminum, niobium, cobalt, and nickel. When A in the above formula is a metal element, A is preferably titanium or aluminum; and the metal oxide is more preferably TiO₂, or Al₂O₅, in terms of favorably adjusting the color tone of the laminated sheet. The metal oxides may be used singly, or in a combination of two or more.

From the viewpoint of transparency and durability such as discoloration resistance, and to make it easy to adjust color, X in the above formula is preferably n/2.4 or more and n/2 or less, more preferably n/2.3 or more and n/2 or less, even more preferably n/2.2 or more and n/2 or less, and particularly preferably n/2.1 or more and n/2 or less.

The thickness of the oxide layer is not particularly limited, and is, for example, 1 to 50 nm. The thickness is preferably 2 to 20 nm, more preferably 3 to 10 nm, to simultaneously achieve an improvement in transparency and durability such as discoloration resistance, as well as easy adjustment of color.

The layer structure of the oxide layer is not particularly limited. The oxide layer may be a single layer composed of one layer, or may be composed of a plurality of layers having the same or different compositions.

### 1-4. Characteristics

In order to further suppress an increase in the surface temperature due to heat rays, the surface of the laminated sheet of the present invention on the metal layer side preferably has an infrared reflectance of 20% or more, more preferably 30% or more, still more preferably 40% or more, and even more preferably 50% or more. The upper limit of the infrared reflectance is not particularly limited, and is, for example, 90%, 80%, or 70%.

In this specification, the infrared reflectance refers to reflectance at a wavelength of 1,000 nm measured with a spectrophotometer. Reflectance measurement using a spectrophotometer can be performed in accordance with JIS K 7105.

The laminated sheet of the present invention is a lustrous sheet. For example, the laminated sheet of the present invention has a gloss value of, for example, 2 or more, preferably 3 or more, more preferably 4 or more, still more preferably 5 or more, and even more preferably 6 or more. The upper limit of the gloss value is not particularly limited, and is, for example, 15, 12, 10, or 8. The gloss value can be measured in accordance with ISO 2813/JIS K5600.

The laminated sheet of the present invention has durability, in particular, discoloration resistance. For example, the laminated sheet of the present invention has a color difference of the surface on the metal layer side (color difference ΔE*ab in the L*a*b* color space measured in accordance with JIS Z8781-4: 2013) of preferably 10 or less, more preferably 5 or less, and still more preferably 3 or less, before and after high-temperature and high-humidity treatment (allowing the sheet to stand for 120 hours under the conditions of 85°C and 85% RH) The lower limit of the color difference is not particularly limited, and is, for example, 0.01, 0.03, or 0.1.

### 1-5. Production Method

The laminated sheet of the present invention can be obtained by a method comprising a step of attaching a metal layer to the surface of a fiber substrate. When the metal layer is composed of a plurality of layers, the laminated sheet can be obtained by a method further comprising a step of attaching another metal layer to the surface of the outermost metal layer. The laminated sheet that comprises an oxide layer can be obtained by a method further comprising a step of attaching an oxide layer to the surface of the metal layer.

Although there is no particular limitation, the attachment can be performed by, for example, a sputtering method, a vacuum deposition method, an ion plating method, a chemical vapor deposition method, a pulsed laser deposition method, or like method. Among these, a sputtering method is preferable, in terms of film thickness controllability.

The sputtering method is not particularly limited. Examples include direct-current magnetron sputtering, radiofrequency magnetron sputtering, ion beam sputtering, and the like. Further, the sputtering apparatus may be batch or roll-to-roll.

### 2. Coated Fiber and Coated Fiber Bundle

In one embodiment, the present invention relates to a coated fiber comprising a fiber and a metal layer disposed on a surface of the fiber (sometimes referred to as "the coated fiber of the present invention" in the present specification). Further, in one embodiment, the present invention relates to a coated fiber bundle comprising a plurality of the coated fibers of the present invention (sometimes referred to as "the coated fiber bundle of the present invention" in the present specification). The coated fiber and coated fiber bundle are described below.

The coated fiber of the present invention preferably further comprises an oxide layer on the surface of the metal layer on a side opposite to the fiber substrate side.

The fiber, fiber bundle, metal layer, oxide layer, production method, and the like are the same as described above in the section "1. Laminated sheet."

In the coated fiber of the present invention, the metal layer is disposed on the fiber surface; specifically, the metal layer is disposed on at least a part (for example, 30% or more, preferably 50% or more, more preferably 70% or more, and usually 100% or less, of the total surface area) of the fiber substrate surface or the entire fiber substrate surface.

The laminated sheet of the present invention can be formed by at least one member selected from the group consisting of the coated fiber of the present invention and the coated fiber bundle of the present invention, alone or in combination with at least one member selected from the group consisting of fibers and fiber bundles.

### 3. Use

The laminated sheet of the present invention, the coated fiber of the present invention, and the coated fiber bundle of the present invention have more remaining unevenness that is originally from the fiber substrate, the fiber, the fiber bundle, etc., have luster, and have improved heat ray reflection. Thus, they can be used as a fiber material with further improved designability and functions in various field. For example, they can be used as a heat-ray-reflective material or a composite material of a fiber and a resin.

From this viewpoint, in one embodiment, the present invention relates to a composite material comprising at least one member selected from the group consisting of the laminated sheet of the present invention, the coated fiber of the present invention, and the coated fiber bundle of the present invention (collectively, "the fiber material of the present invention"); and a resin (sometimes referred to as "the composite material of the present invention" in the present specification). The composite material is described below.

The composite material of the present invention is not particularly limited as long as it comprises the fiber material of the present invention and a resin. The composite material of the present invention is preferably a fiber-reinforced plastic in which the fiber material of the present invention is contained in a resin, which is a base material.

The resin is not particularly limited, and various resins can be used. Examples of the resin include polyamide-based resins (e.g., nylon), polyphenylene ethers, polyoxymethylene, polybutylene terephthalate, polycarbonate, polymethyl methacrylate (PMMA), polystyrene, polypropylene, polyetherimide, polyethersulfone, and the like.

The composite material of the present invention can be produced according to a usual method and can be used in various applications, such as structural materials for producing automobiles (in particular, automobile interior and exterior materials), aircraft, sports products (e.g., golf shafts, tennis rackets, badminton rackets, fishing rods, skis, snowboards, bats, archery, bicycles, boats, canoes, yachts, and windsurfing), medical devices, building materials, electrical equipment (e.g., cases of personal computers and the like, and speaker cones), and the like.

In one embodiment of the present invention, use as an automobile interior and exterior material is also provided.

### Examples

The present invention is described in detail below with reference to Examples. However, the present invention is not limited to these Examples.

### (1) Production of Laminated Sheet

### Example 1

A twill-woven fabric (TR3523 M, produced by Mitsubishi Chemical Corporation; thickness: 0.21 mm), which is made from carbon fibers (areal weight: 200 g/m², filament diameter: 7 µm, density: 12.5 fibers/inch), was used as a fiber substrate.

The fiber substrate was placed in a vacuum apparatus, followed by vacuum evacuation to 5.0 × 10⁻⁴ Pa or less. Subsequently, argon gas was introduced, and a Ti layer (average thickness: 25 nm) was formed as a metal layer 1 on the surface of the fiber substrate by a DC magnetron sputtering method, thereby obtaining a laminated sheet.

### Example 2

A laminated sheet was obtained in the same manner as in Example 1, except that a Ti layer (average thickness: 50 nm) was formed as the metal layer 1.

### Example 3

A laminated sheet was obtained in the same manner as in Example 1, except that an Al layer (average thickness: 25 nm) was formed as the metal layer 1.

### Example 4

A laminated sheet was obtained in the same manner as in Example 1, except that an Al layer (average thickness: 50 nm) was formed as the metal layer 1.

### Example 5

A laminated sheet was obtained in the same manner as in Example 1, except that an Ag layer (average thickness: 25 nm) was formed as the metal layer 1.

### Example 6

A laminated sheet was obtained in the same manner as in Example 1, except that an Ag layer (average thickness: 50 nm) was formed as the metal layer 1.

### Example 7

The fiber substrate used in Example 1 was placed in a vacuum apparatus, followed by vacuum evacuation to 5.0 × 10⁻⁴ Pa or less. Subsequently, argon gas was introduced, and an Al layer (average thickness: 50 nm) was formed on the surface of the fiber substrate as a metal layer 1 by a DC magnetron sputtering method, thereby obtaining a laminate comprising the fiber substrate and the metal layer 1.

The laminate comprising the fiber substrate and the metal layer 1 was placed in a vacuum apparatus, followed by vacuum evacuation to 5.0 × 10⁻⁴ Pa or less. Subsequently, argon gas was introduced, and a Ti layer (average thickness: 3 nm) was formed as a metal layer 2 on the surface of the metal layer 1 on a side opposite to the fiber substrate side by a DC magnetron sputtering method, thereby obtaining a laminated sheet.

### Example 8

A laminated sheet was obtained in the same manner as in Example 7, except that a Ti layer (average thickness: 6 nm) was formed as the metal layer 2.

### Example 9

A laminated sheet was obtained in the same manner as in Example 7, except that a Ti layer (average thickness: 9 nm) was formed as the metal layer 2.

### Example 10

A laminated sheet was obtained in the same manner as in Example 7, except that an Ag layer (average thickness: 50 nm) was formed as the metal layer 1, and a Ti layer (average thickness: 3 nm) was formed as the metal layer 2.

### Example 11

A laminated sheet was obtained in the same manner as in Example 7, except that an Ag layer (average thickness: 50 nm) was formed as the metal layer 1, and a Ti layer (average thickness: 6 nm) was formed as the metal layer 2.

### Example 12

A laminated sheet was obtained in the same manner as in Example 7, except that an Ag layer (average thickness: 50 nm) was formed as the metal layer 1, and a Ti layer (average thickness: 9 nm) was formed as the metal layer 2.

### Example 13

A laminated sheet was obtained in the same manner as in Example 7, except that a Ti layer (average thickness: 35 nm) was formed as the metal layer 1, and a FeNiCr alloy (stainless steel: SUS310S) layer (average thickness: 5 nm) was formed as the metal layer 2.

### Example 14

A laminated layer was obtained in the same manner as in Example 7, except that a Ti layer (average thickness: 50 nm) was formed as the metal layer 1, and a FeNiCr alloy (stainless steel: SUS310S) layer (average thickness: 5 nm) was formed as the metal layer 2.

### Example 15

A laminated sheet was obtained in the same manner as in Example 7, except that a Ti layer (average thickness: 25 nm) was formed as the metal layer 2.

### Example 16

The fiber substrate used in Example 1 was placed in a vacuum apparatus, followed by vacuum evacuation to 5.0 × 10⁻⁴ Pa or less. Subsequently, argon gas was introduced, and a Ti layer (average thickness: 25 nm) was formed as a metal layer 1 on the surface of the fiber substrate by a DC magnetron sputtering method, thereby obtaining a laminate comprising the fiber substrate and the metal layer 1.

The laminate comprising the fiber substrate and the metal layer 1 was placed in a vacuum apparatus, followed by vacuum evacuation to 5.0 × 10⁻⁴ Pa or less. Subsequently, argon gas was introduced, and an SiO₂ layer (average thickness: 5 nm) was formed as an oxide layer on the surface of the metal layer 1 on a side opposite to the fiber substrate side by a DC magnetron sputtering method, thereby obtaining a laminated sheet.

### Example 17

The fiber substrate used in Example 1 was placed in a vacuum apparatus, followed by vacuum evacuation to 5.0 × 10⁻⁴ Pa or less. Subsequently, argon gas was introduced, and an Al layer (average thickness: 50 nm) was formed as a metal layer 1 on the surface of the fiber substrate by a DC magnetron sputtering method, thereby obtaining a laminate comprising the fiber substrate and the metal layer 1.

The laminate of the fiber substrate and the metal layer 1 was placed in a vacuum apparatus, followed by vacuum evacuation to 5.0 × 10⁻⁴ Pa or less. Subsequently, argon gas was introduced, and a Ti layer (average thickness: 6 nm) was formed as a metal layer 2 on the surface of the metal layer 1 on a side opposite to the fiber substrate side by a DC magnetron sputtering method, thereby obtaining a laminate comprising the fiber substrate, the metal layer 1, and the metal layer 2.

The laminate comprising the fiber substrate, the metal layer 1, and the metal layer 2 was placed in a vacuum apparatus, followed by vacuum evacuation to 5.0 × 10⁻⁴ Pa or less. Subsequently, argon gas was introduced, and an SiO₂ layer (average thickness: 5 nm) was formed as an oxide layer on the surface of the metal layer 2 on a side opposite to the fiber substrate side by a DC magnetron sputtering method, thereby obtaining a laminated sheet.

### Example 18

A laminated sheet was obtained in the same manner as in Example 7, except that a Si layer (average thickness: 8 nm) was formed as the metal layer 2 by a RF magnetron sputtering method.

### (2) Preparation of Comparative Sheet

### Comparative Example 1

The fiber substrate used in Example 1 was directly used as a comparative sheet.

### (3) Evaluation

### Evaluation of Color

The L*, a*, and b* in the L*a*b* color space of the surface of the laminated sheet on the metal layer side and the surface of the fiber substrate were determined using a spectrophotometer (CM-2500d, produced by Konica Minolta, Inc.) according to JIS Z8781-4 (2013). The surface of each laminated sheet and the surface of the fiber substrate were measured at five points, and the average value was used.

### Evaluation of Luster

The gloss value of the surface of the laminated sheet on the metal layer side and the surface of the comparative sheet was measured using a spectrophotometer (CM-25cG, produced by Konica Minolta, Inc.) in accordance with ISO 2813/JIS K5600. The surface of each laminated sheet and the surface of the fiber substrate were measured at five points, and the average value was used.

### Measurement of Infrared (IR) Reflectance

The reflectance of the laminated sheet was measured at a wavelength of 1,000 nm using a spectrophotometer (V-670 produced by JASCO Corporation) in accordance with JIS K 7105. Each laminated sheet was measured at three points, and the average value was used.

### Measurement of Surface Temperature

The surface of each laminated sheet on the metal layer side and the surface of the comparative sheet were irradiated with a lamp (an IR100/110V375WRH EYE infrared bulb, produced by Iwasaki Electric Co., Ltd.) at 375 W for 10 minutes at a distance of 25 cm or 50 cm, and the surface temperature after irradiation was measured with a thermocouple.

### Measurement of Discoloration Resistance

L*, a*, and b* in the L*a*b* color space of the surface of each laminated sheet on the metal layer side and the surface of each fiber substrate were determined using a spectrophotometer (CM-2500d, produced by Konica Minolta, Inc.) according to JIS Z8781-4 (2013). After the measurement, each laminated sheet was placed in a high-temperature and high-humidity chamber, and allowed to stand under the conditions of 85°C/85% RH for 120 hours. Thereafter, L*, a*, and b* in the L*a*b* color space of the surface were measured in the same manner. From L*, a*, and b* before and after the high-temperature and high-humidity test, the color difference ΔE*ab in the L*a*b* color space of the surface of the laminated sheet was determined according to JIS Z8781-4 (2013) .

Tables 1 and 2 below show the results.

**Table 1**

| | | | Ex. 1 | Ex. 2 | Ex. 3 | Ex. 4 | Ex. 5 | Ex. 6 | Ex. 7 | Ex. 8 | Ex. 9 |
|---|---|---|---|---|---|---|---|---|---|---|---|
| Metal layer 1 (internal layer) | | Material | Ti | Ti | Al | Al | Ag | Ag | Al | Al | Al |
| | | Thickness | 25 | 50 | 25 | 50 | 25 | 50 | 50 | 50 | 50 |
| Metal layer 2 (external layer) | | Material | - | - | - | - | - | - | Ti | Ti | Ti |
| | | Thickness | - | - | - | - | - | - | 3 | 6 | 9 |
| Oxide layer | | Material | - | - | - | - | - | - | - | - | - |
| | | Thickness | - | - | - | - | - | - | - | - | - |
| Color (before high-temperature and high-humidity test) | | L* | 47.6 | 55.3 | 66.9 | 70.4 | 62.3 | 76.3 | 73.0 | 70.7 | 66.2 |
| | | a* | 0.8 | 0.9 | -0.1 | -0.1 | 1.0 | 0.2 | -0.1 | 0.5 | 0.9 |
| | | b* | 3.7 | 3.1 | 2.9 | 4.9 | 10.1 | 6.4 | 3.8 | 6.3 | 6.7 |
| Color (after high-temperature and high-humidity test) | | L* | 46.8 | 53.9 | 65.8 | 69.5 | 61.8 | 76.0 | 72.5 | 70.1 | 64.9 |
| | | a* | 1.2 | 1.2 | 0.0 | 0.1 | 3.3 | 2.9 | -0.6 | -0.3 | 0.5 |
| | | b* | 4.2 | 3.1 | 3.1 | 5.3 | 8.9 | 6.2 | 3.1 | 6.9 | 6.8 |
| Color difference ΔE*ab before and after high-temperature and high-humidity test | | | 1.0 | 1.5 | 1.2 | 1.1 | 2.7 | 2.7 | 1.0 | 1.2 | 1.4 |
| Luster | | Gloss | 2.9 | 3.4 | 5.5 | 7.6 | 4.8 | 7.1 | 7.0 | 6.3 | 5.7 |
| IR reflectance | | % | 23 | 32 | 45 | 55 | 49 | 61 | 56 | 55 | 54 |
| Surface temperature | 25 cm | °C | 112 | 111 | 108 | 106 | 105 | 103 | 105 | 106 | 106 |
| | 50 cm | °C | 49 | 48 | 44 | 43 | 43 | 38 | 43 | 44 | 45 |

**Table 2**

| | | | Ex. 10 | Ex. 11 | Ex. 12 | Ex. 13 | Ex.14 | Ex. 15 | Ex. 16 | Ex. 17 | Ex. 18 | Comp. Ex. 1 |
|---|---|---|---|---|---|---|---|---|---|---|---|---|
| Metal layer 1 (internal layer) | | Material | Ag | Ag | Ag | Ti | Ti | Al | Ti | Al | Al | - |
| | | Thickness | 50 | 50 | 50 | 35 | 50 | 50 | 25 | 50 | 50 | - |
| Metal layer 2 (external layer) | | Material | Ti | Ti | Ti | FeNiCr | FeNiCr | Ti | - | Ti | Si | - |
| | | Thickness | 3 | 6 | 9 | 5 | 5 | 25 | - | 6 | 8 | - |
| Oxide layer | | Material | - | - | - | - | - | - | SiO₂ | SiO₂ | - | - |
| | | Thickness | - | - | - | - | - | - | 5 | 5 | - | - |
| Color (before high-temperature and high-humidity test) | | L* | 68.8 | 63.6 | 58.8 | 58.5 | 58.1 | 48.7 | 54.8 | 69.8 | 43.0 | 11.0 |
| | | a* | 1.1 | 2.0 | 2.0 | 0.2 | 0.2 | 0.9 | 0.9 | 0.4 | 11.0 | 2.1 |
| | | b* | 11.3 | 12.8 | 10.8 | 1.7 | 1.9 | 3.9 | 3.2 | 6.2 | 24.7 | 5.9 |
| Color (after high-temperature and high-humidity test) | | L* | 66.8 | 61.8 | 56.9 | 57.8 | 56.9 | 48.5 | 54.9 | 69.3 | 42.1 | 10.2 |
| | | a* | 3.8 | 4.2 | 4.1 | 0.5 | 0.4 | 0.2 | 1.1 | 0.3 | 11.3 | 3.1 |
| | | b* | 10.5 | 11.0 | 9.8 | 1.8 | 1.5 | 4.6 | 3.5 | 6.3 | 22.7 | 6.7 |
| Color difference ΔE*ab before and after high-temperature and high-humidity test | | | 3.5 | 3.4 | 3.0 | 0.8 | 1.3 | 1.0 | 0.4 | 0.5 | 2.2 | 1.5 |
| Luster | | Gloss | 6.7 | 5.3 | 4.6 | 2.8 | 3.7 | 2.9 | 3.3 | 6.1 | 5.4 | 1.5 |
| IR reflectance | | % | 62 | 57 | 52 | 25 | 28 | 41 | 23 | 52 | 38 | 12 |
| Surface temperature | 25 cm | °C | 103 | 103 | 105 | 112 | 113 | 110 | 111 | 106 | 112 | 120 |
| | 50 cm | °C | 39 | 41 | 43 | 48 | 47 | 44 | 49 | 45 | 44 | 51 |

The results revealed that the laminated sheets of Examples 1 to 17 had a significantly higher L value and were colored, compared to the sheet of Comparative Example 1, which had an L value as dark as about 10. Further, the laminated sheets of Examples 1 to 17 had more excellent luster than the sheet of Comparative Example 1. The results further revealed that the laminated sheets of Examples 1 to 17 had higher infrared (IR) reflectance than that of the sheet of Comparative Example 1, and that the increase in the surface temperature of the laminated sheets of Examples 1 to 17 due to heat rays was suppressed.

Additionally, visual observation of the surface of the laminated sheets of Examples 1 to 17 on the metal layer side confirmed the surface pattern without the unevenness of the fiber substrate being deteriorated.

## Claims

1. A laminated sheet comprising a fiber substrate and a metal layer disposed on a surface of the fiber substrate.

2. The laminated sheet according to claim 1, wherein the metal layer contains at least one member selected from the group consisting of aluminum, copper, iron, silver, gold, chromium, nickel, molybdenum, titanium, platinum, germanium, indium, and silicon.

3. The laminated sheet according to claim 1 or 2, further comprising an oxide layer on a surface of the metal layer opposite to the fiber substrate.

4. The laminated sheet according to any one of claims 1 to 3, wherein the surface of the laminated sheet on the metal layer side has an infrared reflectance of 50% or more.

5. The laminated sheet according to any one of claims 1 to 4, wherein the metal layer is composed of two or more layers having different compositions.

6. The laminated sheet according to claim 5,
wherein the outermost layer of the metal layer on a side opposite to the fiber substrate side is composed of a metal, alloy, or compound comprising at least one member selected from the group consisting of titanium, aluminum, silver, iron, copper, indium, and silicon, and
wherein the outermost layer has a thickness of 3 to 20 nm.

7. The laminated sheet according to any one of claims 1 to 6, wherein the fiber substrate is a sheet comprising carbon fiber.

8. The laminated sheet according to any one of claims 1 to 7, for use as a heat-ray-reflecting material.

9. A coated fiber comprising a fiber and a metal layer disposed on a surface of the fiber.

10. A composite material comprising a resin and at least one member selected from the group consisting of the laminated sheet of any one of claims 1 to 8 and the coated fiber of claim 9.

11. The composite material according to claim 10, for use as an automobile interior and exterior material.
